# EUROPEAN PATENT SPECIFICATION

(11) **EP 4 572 549 B1**
(45) Date of publication and mention of the grant of the patent: **21.10.2026**
(21) Application number: 23307233.9
(22) Date of filing: 15.12.2023
(51) Int. Cl.: H05K 7/20

(54) **A DEPURATING SYSTEM FOR LIQUID-COOLED RACK-MOUNTED PROCESSING ASSEMBLIES**
REINIGUNGSSYSTEM FÜR FLÜSSIGKEITSGEKÜHLTE GESTELLMONTIERTE VERARBEITUNGSANORDNUNGEN
SYSTÈME DE PURGE POUR ENSEMBLES DE TRAITEMENT MONTÉS SUR BÂTI REFROIDIS PAR LIQUIDE

(43) Date of publication of application: 18.06.2025
(73) Proprietor: OVH, 59100 Roubaix (FR)
(72) Inventor: CHEHADE, Ali, 59283 Moncheaux (FR); BAUCHART, Grégory Francis Louis, 59150 Wattrelos (FR); HNAYNO, Mohamad, 59100 Roubaix (FR)
(74) Representative: BCF Global

(56) References cited:
- EP-A1- 2 165 585
- US-A1- 2020 025 451

## Description

### FIELD

The present technology generally relates to the field of datacenter liquid cooling arrangements and, in particular, to the replacement of legacy cooling liquids with a depurating liquid to service the liquid cooling needs of rack-mounted processing assemblies.

### BACKGROUND

Datacenters as well as many computer processing facilities house multitudes rack-mounted electronic processing components. In operation, such electronic processing components generate a substantial amount of heat that must be dissipated in order avoid electronic component failures and ensure continued efficient processing operations.

To this end, various liquid cooling measures have been implemented to facilitate the dissipation of heat generated by the electronic processing components. One such measure, is the use of an immersion liquid cooling technique, in which electronic components are fully submerged in a rack casing containing a non-conductive cooling liquid, such as, for example, a dielectric cooling liquid. The immersion of the electronic components within the dielectric cooling liquid achieves adequate thermal contact between the electronic components to dissipate a fair amount of generated heat.

For example, US Pat. Pub. No. US 2020/025451 is directed to a method of operating a cooling system including at least two water cooling circuits, an analyzer/controller configured to analyze water in the at least two water cooling circuits and solenoid valves operably connected to the at least two water cooling circuits. The method comprising opening solenoid valves associated with a first water cooling circuit of the at least two water cooling circuits to allow cooling water to flow to the analyzer/controller, detecting if the cooling water comprises one or more impurities above one or more predetermined thresholds and treating the cooling water if the analyzer/cooler detects one or more impurities in the cooling water above one or more predetermined thresholds.

As another example, EP No. 2165585 (WO 2008/147469) is directed to a system of cooling and method of use that includes a connector (106) having a data reader capable of reading a wireless identifier and/or a breaker box (108) capable of routing liquid cooling to at least one server (100). In a preferred embodiment, both the quick connector and the breaker box are used in conjunction with a liquid coolant such as refrigerant or water.

However, there are certain electronic components, such as, for example, high-performance processing units that tend to generate more heat than other electronic components (e.g., memory boards) and dielectric liquid immersion measures may not serve to sufficiently cool such high heat-generating components. To address the cooling of these high heat-generating components, direct liquid cooling block measures have been implemented, in which liquid cooling blocks having internal channels to circulate cool water therethrough are disposed in direct thermal contact with the high heat-generating components.

The Inventors of the instant application have identified evidence of undesirable contaminants that develop, over time, due to the circulation of channelized water throughout the liquid cooling blocks and corresponding distribution channels and coupling elements. Such evidence of undesirable contaminants includes the buildup of mineral deposits, corrosion, algae, bacteria, *etc.* that affect the quality of the water as well as the efficient flow of the channelized water.

Hence, there is an interest in eliminating the buildup of such undesirable contaminants as well as reducing reoccurrences of the same in direct liquid cooling block implementations.

The subject matter discussed in the background section should not be assumed to be prior art merely as a result of its mention in the background section. Similarly, a problem mentioned in the background section or associated with the subject matter of the background section should not be assumed to have been previously recognized in the prior art. The subject matter in the background section merely represents different approaches.

### SUMMARY

Implementations of the present technology have been developed based on certain drawbacks associated with conventional liquid cooling techniques and implementations. The invention is defined in appended independent claims. Preferred embodiments are to be found in appended dependent claims.

In one aspect, the present technology provides a depurating system for a server rack housing rack-mounted processing assemblies that are cooled by respective liquid cooling blocks channeling a cooling liquid via a liquid cooling loop that incorporates a depurating apparatus comprising: a tank containing a volume of liquid treated with cleansing additives, a control module configured to monitor, determine, and control at least one operational parameter regarding the treated liquid, a fluid control structure operably-coupled to the control module and configured to adjust the at least one operational parameter of the treated liquid based on determinations provided by the control module, a fluid coupling section fluidly-coupled to the fluid control structure and configured to supply the treated liquid to the server rack, a server rack fluid inlet fluidly-connected to the fluid coupling section for receiving the supplied treated liquid and fluidly-coupled to an input side of the liquid cooling loop for injecting the treated liquid for distribution throughout the processing assemblies of the server rack, and a server rack fluid outlet fluidly-coupled to an output side of the liquid cooling loop for receiving the existing cooling liquid displaced by the injected treated liquid; wherein the injection of the treated liquid functions to purge the existing cooling liquid away from the rack-mounted processing assemblies of the server rack and replace the purged existing cooling liquid with the treated liquid while maintaining continued operations of the rack-mounted processing assemblies.

The depurating system further incorporates a purging pipe fluidly-coupled to the server rack unit fluid outlet and configured to receive the purged existing cooling liquid; and a liquid quality sensor (LQS) fluidly-coupled to the purging pipe for measuring quality levels of the purged existing liquid.

The depurating system provides that the treated liquid comprises reversed osmosed water containing at least one corrosion inhibiting agent and is configured to manifest certain quality levels, such as, having a pH balance of approximately between 8 and 10, an electrical conductivity of approximately less than 170 (µS/cm), an aluminum, copper, and zinc content of approximately less than 0.6 ppm and an aerobic microorganism content of approximately less than 1000 cfu/ml.

The depurating system further provides that the fluid control structure comprises at least one pump, at least one pressure sensor, at least one filter, an expansion tank, and at least one check control valve and that the fluid coupling section comprises at least one pressure control valve, at least one air vent isolation valve, and at least one shutoff flow valve.

The depurating system also provides that the injection of the treated liquid as well as the purging of the existing liquid is performed until a predetermined duration time t has lapsed.

The depurating system additionally provides that the injection of the treated liquid as well as the purging of the existing liquid is performed until quality levels of the purged existing cooling liquid, as measured by the LQS, matches the treated liquid quality levels.

In another aspect, the present technology provides a depurating process for a server rack housing rack-mounted processing assemblies that are cooled by respective liquid cooling blocks channeling a cooling liquid via a liquid cooling loop that comprises: detecting an internal volume and pressure of a liquid tank (110A) containing a treated depurating liquid, the treated depurating liquid comprising reversed osmosed water containing at least one corrosion inhibiting agent; determining whether the internal volume and/or pressure of the treated liquid tank is below an acceptable threshold value; upon determining that the internal volume and/or pressure of the treated liquid tank is below the acceptable threshold value, shut down the process and send an alert message. And, upon determining that the internal volume and/or pressure of the treated liquid tank meets the acceptable threshold value, execute the depurating process by actuating pumps corresponding to liquid distribution chains of the treated liquid; selecting at least one of the liquid distribution chains for distributing the treated liquid to the rack-mounted processing assembly; activate an expansion tank to ensure constant pressure and volume of the treated liquid to be distributed to the rack-mounted processing assembly; and commence injection flow of the treated liquid into the liquid cooling loop of the server rack unit. The process operates such that the injection flow of the treated liquid functions to purge existing cooling liquid from the rack-mounted processing assemblies of the server rack and replace the purged existing cooling liquid with the treated liquid while maintaining continued operations of the rack-mounted processing assemblies.

Moreover, in one implementation the depurating process is performed until a predetermined duration time t has lapsed. And, in another implementation, the depurating process is performed until quality levels of the purged existing cooling liquid match the treated liquid quality levels.

In the context of the present specification, unless expressly provided otherwise, a computer system may refer, but is not limited to, an "electronic device", an "operation system", a "system", a "computer-based system", a "controller unit", a "monitoring device", a "control device" and/or any combination thereof appropriate to the relevant task described.

Furthermore, in the context of the present specification, unless expressly provided otherwise, the expression "computer-readable medium" and "memory" are intended to include media of any nature and kind whatsoever, non-limiting examples of which include RAM, ROM, disks (CD-ROMs, DVDs, floppy disks, hard disk drives, etc.), USB keys, flash memory cards, solid state-drives, and tape drives. Still in the context of the present specification, "a" computer-readable medium and "the" computer-readable medium should not be construed as being the same computer-readable medium. To the contrary, and whenever appropriate, "a" computer-readable medium and "the" computer-readable medium may also be construed as a first computer-readable medium and a second computer-readable medium.

Additionally, in the context of the present specification, unless expressly provided otherwise, the words "first", "second", "third", etc. have been used as adjectives only for the purpose of allowing for distinction between the nouns that they modify from one another, and not for the purpose of describing any particular relationship between those nouns.

Implementations of the present technology each have at least one of the above-mentioned object and/or aspects, but do not necessarily have all of them. It should be understood that some aspects of the present technology that have resulted from attempting to attain the above-mentioned object may not satisfy this object and/or may satisfy other objects not specifically recited herein.

Additional and/or alternative features, aspects, and advantages of implementations of the present technology will become apparent from the following description, the accompanying drawings and the appended claims.

### BRIEF DESCRIPTION OF THE DRAWINGS

For a better understanding of the present technology, as well as other aspects and further features thereof, reference is made to the following description which is to be used in conjunction with the accompanying drawings, where:
FIG. 1 illustrates a high-level functional block diagram of a depurating system, in accordance with the nonlimiting implementations of the present technology;
FIG. 2A illustrates a high-level functional block diagram of a fluid control structure for the depurating system, in accordance with the nonlimiting implementations of the present technology;
FIG. 2B illustrates a high-level functional block diagram of a fluid coupling section for the depurating system, in accordance with the nonlimiting implementations of the present technology;
FIG. 3 illustrates a high-level schematic of the fluid coupling section connected to rack units for the depurating system, in accordance with the nonlimiting implementations of the present technology;
FIG. 4 illustrates a high-level flow diagram for the depurating process, in accordance with the nonlimiting implementations of the present technology; and
FIG. 5 is block diagram of a controller in accordance with an implementation of the present technology.

It should be appreciated that, unless otherwise explicitly specified herein, the drawings are not to scale.

### DETAILED DESCRIPTION

The examples and conditional language recited herein are principally intended to aid the reader in understanding the principles of the present technology and not to limit its scope to such specifically recited examples and conditions. It will be appreciated that those skilled in the art may devise various arrangements that, although not explicitly described or shown herein, nonetheless embody the principles of the present technology.

Furthermore, as an aid to understanding, the following description may describe relatively simplified implementations of the present technology. As persons skilled in the art would understand, various implementations of the present technology may be of a greater complexity.

In some cases, what are believed to be helpful examples of modifications to the present technology may also be set forth. This is done merely as an aid to understanding, and, again, not to define the scope or set forth the bounds of the present technology. These modifications are not an exhaustive list, and a person skilled in the art may make other modifications while nonetheless remaining within the scope of the present technology. Further, where no examples of modifications have been set forth, it should not be interpreted that no modifications are possible and/or that what is described is the sole manner of implementing that element of the present technology.

Moreover, all statements herein reciting principles, aspects, and implementations of the present technology, as well as specific examples thereof, are intended to encompass both structural and functional equivalents thereof, whether they are currently known or developed in the future. Thus, for example, it will be appreciated by those skilled in the art that any block diagrams herein represent conceptual views of illustrative circuitry embodying the principles of the present technology. Similarly, it will be appreciated that any flowcharts, flow diagrams, state transition diagrams, pseudo-code, and the like represent various processes that may be substantially represented in non-transitory computer-readable media and so executed by a computer or processor, whether or not such computer or processor is explicitly shown.

The functions of the various elements shown in the FIGs. including any functional block labeled as a "processor", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. In some implementations of the present technology, the processor may be a general-purpose processor, such as a central processing unit (CPU) or a processor dedicated to a specific purpose, such as a digital signal processor (DSP). Moreover, explicit use of the term a "processor" should not be construed to refer exclusively to hardware capable of executing software, and may implicitly include, without limitation, application specific integrated circuit (ASIC), field programmable gate array (FPGA), read-only memory (ROM) for storing software, random access memory (RAM), and non-volatile storage. Other hardware, conventional and/or custom, may also be included.

Software modules, or simply modules which are implied to be software, may be represented herein as any combination of flowchart elements or other elements indicating performance of process steps and/or textual description. Such modules may be executed by hardware that is expressly or implicitly shown. Moreover, it should be understood that module may include for example, but without being limitative, computer program logic, computer program instructions, software, stack, firmware, hardware circuitry or a combination thereof which provides the required capabilities.

Given this fundamental understanding, the disclosed implementations are directed to a depurating system for liquid-cooled rack-mounted processing assemblies that is configured to eliminate the buildup of undesirable contaminants and replace liquid cooling liquid with a treated fluid reduce reoccurrences of the same in direct liquid cooling block implementations. The depurating system is capable of performing the depurating process while the processing assemblies are in operation with no downtime.

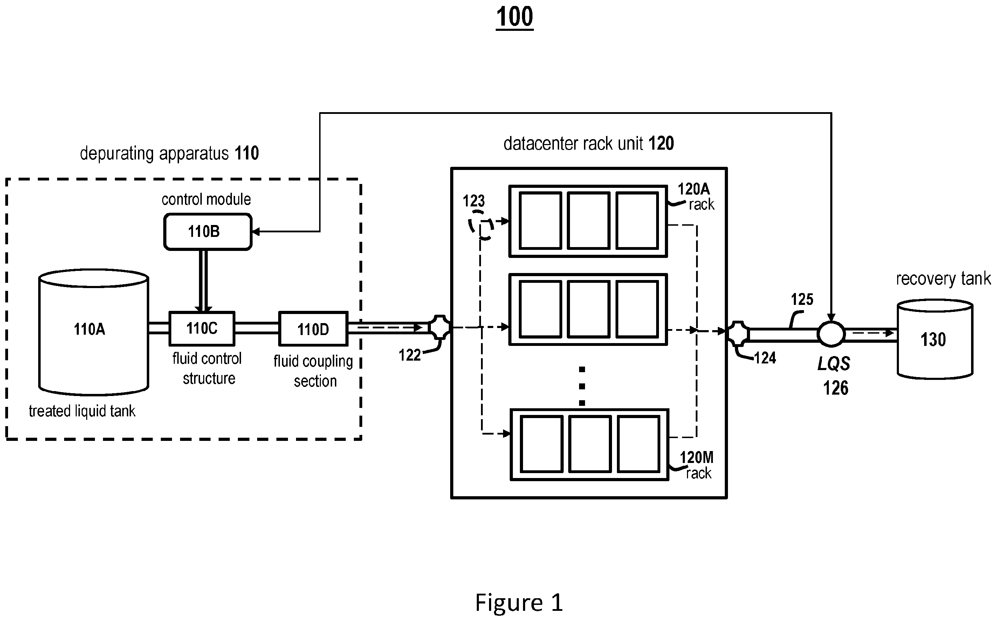

FIG. 1 illustrates a high-level functional block diagram of a depurating system **100,** in accordance with the nonlimiting implementations of the present technology. As depicted, depurating system **100** generally comprises a depurating apparatus **110** that is in fluid communication and contact with a datacenter rack unit **120.**

Starting with the datacenter rack unit **120,** the rack unit **120** houses a plurality of racks, in which each rack comprises one or more rack-mounted processing assemblies **120A-120M.** Each of the rack-mounted processing assemblies **120A-120M** contain heat-generating processing components *(not shown)* which are cooled by liquid cooling blocks *(not shown)* that are arranged to be in direct thermal contact with the heat-generating components. In tum, each of the liquid cooling blocks employ internal channels that are fluidly-coupled to a server rack liquid cooling loop **123** which conveys cool liquid (e.g water) and circulates the channelized cool liquid throughout the liquid cooling blocks. The server rack liquid cooling loop **123** may be constructed from flexible materials *(e.g.,* rubber, plastic, *etc.),* rigid materials *(e.g.,* metal, PVC piping, *etc.),* or any combination of thereof capable of securely conveying cool liquid.

The datacenter rack unit **120** also implements a rack unit liquid inlet **122,** a rack unit liquid outlet **124,** a purging pipe **125.** In some implementations, the datacenter rack unit **120** may also include a liquid quality sensor (LQS) **126** fluidly connected to the purging pipe **125** as well as operably-connected to a control module **110B** *(see below).* The liquid inlet **122** is fluidly coupled to an input side of the server rack liquid cooling loop **123** to supply cool liquid to the liquid cooling blocks while the liquid outlet **124** is fluidly-coupled to an output side of the liquid cooling loop **123** to receive the existing liquid containing contaminant residues (*i.e.*, "dirty liquid"). The dirty liquid is forwarded to the purge pipe **125** for disposal or recleaning/recirculation, in which the LQS **126** may measure quality levels of the purged dirty liquid. The measured quality levels may include pH balance, electrical conductivity, aluminum, copper, and zinc content, and/or aerobic microorganism.

For depurating purposes, the present technology exploits the infrastructure provided by the rack liquid inlet **122,** rack liquid cooling loop **123,** and rack liquid outlet **124** to circulate a treated liquid throughout the liquid cooling loop **123** and related components and purge the existing dirty liquid from the racks. In certain implementations, a recovery tank **130** may be provided that receives the purged dirty liquid via the purging pipe **125.**

Turning to the depurating apparatus **110,** the apparatus **110** comprises a treated liquid tank **110A,** a control module **110B,** a fluid control structure **110C** operably- and communicatively-coupled to the control module **110B,** and a fluid coupling section **110D.**

The treated liquid tank **110A** is configured to contain a volume of treated liquid containing additives designed to substantially eliminate contaminants and corrosive deposits that have built up within liquid cooling blocks, the server rack liquid cooling loop **123,** and corresponding coupling elements. As will be described below, the treated liquid is to be injected into the server rack liquid cooling loop **123** and circulated therethrough to substantially eliminate contaminants and deposits, purge the existing *(i.e.,* "dirty") liquid containing such impurities, and replace the dirty liquid with the treated liquid. This depurating cycle is to be executed while maintaining the operations of the data processing assemblies **120A-120M** active with no downtime in processing performance.

The treated liquid may include water with certain additives/agents having contaminant cleansing and anticorrosive properties. In certain implementations, the treated liquid comprises reversed osmosed water containing at least one corrosion-inhibiting agent. The treated liquid may be further processed and filtered to manifest certain liquid quality levels, such as, for example, a pH balance of approximately between 8 and 10, an electrical conductivity of approximately less than 170 (µS/cm), an aluminum, copper, and zinc content of approximately less than 0.6 ppm, and an aerobic microorganism content of approximately less than 1000 cfu/ml.

The control module **110B** monitors and determines operational parameters of the treated liquid to be supplied to the rack-mounted processing assemblies **120A-120M** and is operably-coupled to the LQS **126.** Such operational parameters may include pump pressure levels and volume flow levels of the treated liquid to be supplied to the processing assemblies **120A-120M** as well as liquid quality levels being purged therefrom.

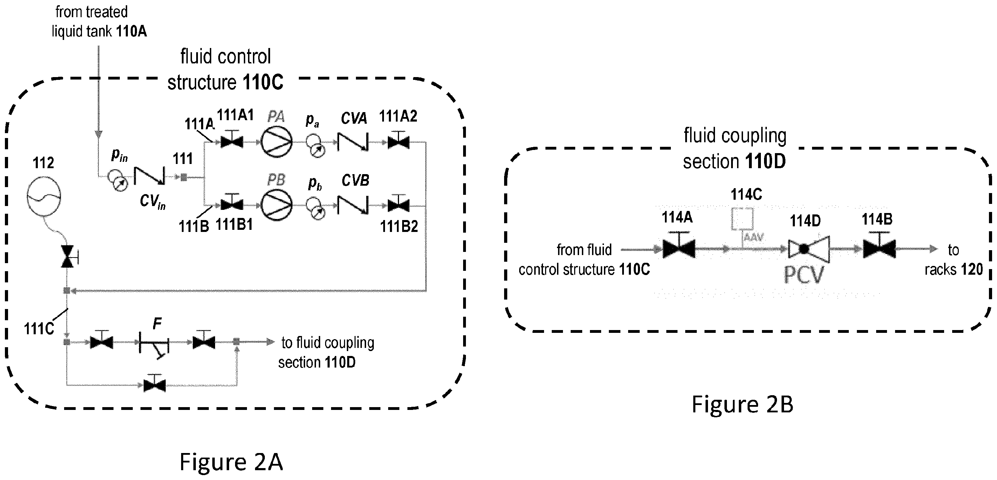

The fluid control structure **110C** is operably- and communicatively-coupled to the control module **110B** and is configured to adjust the at least one operational parameter of the treated liquid based on determinations provided by the control module **110B.** As best seen in FIG. 2A, which illustrates a high-level functional block diagram of the fluid control structure **110C** in accordance with the implementations of the present technology, fluid control structure **110C** includes at least one pump PA, PB, at least one pressure sensor *pᵢₙ, pₐ, p_{b},* at least one check valve CVᵢₙ, CVA, CVB, at least one shutoff control valve **111A1,111A2, 111B1, 111B2,** an expansion tank **112,** and a filter F incorporated along respective liquid distribution chains **111A, 111B, 111C.**

In particular, the control structure **110C** receives the treated liquid and first determines whether the tank pressure/volume are proper based on the measured value by pressure sensor *pᵢₙ.* The control structure **110C** then implements an initial check valve CVᵢₙ to prevent backflow of the treated liquid seeping back into liquid tank **110A.** The treated liquid is then supplied to a junction coupler **111** configured to provide the treated liquid to one or more parallel liquid distribution chains **111A, 111B.**

Each of the parallel liquid distribution chains **111A, 111B** respectively includes a front-end control valve **111A1** (or **111B1)** for allowing/preventing ingress of the treated liquid, a pump PA (or PB) to provide the necessary pressure flow of the treated liquid, a pressure sensor *pₐ* (or *p_{b}*) to detect and confirm the pressure flow, and a check valve CVA (or CVB) to prevent backflow of the treated liquid, and a back-end control valve **111A2** (or **111B2)** for allowing/preventing egress of the treated liquid. By virtue of providing a parallel configuration, either one or both of the distribution chains **111A, 111B** may be selected to supply the required volume and pressure of the treated liquid by virtue of turning on/off the front-end valves **111A1, 111B1** and back-end valves **111A2, 111B2.**

The treated liquid outputted by one or both of the liquid distribution chains **111A, 111B** is received by liquid distribution chain **111C.** As shown, liquid distribution chain **111C** is fluidly coupled to an expansion tank **112** that is configured to ensure that the treated liquid pressure and volume are constant throughout the depurating cycle. The liquid distribution chain **111C** further comprises a filter F to filter out any impurities/contaminants that may have been picked up by the treated liquid as it circulates throughout the components of the liquid distribution chains **111A, 111B** and expansion tank **112.** The liquid distribution chain **111C** also comprises a variety of control shutoff valves for isolating the flow of the treated liquid.

As noted above, the operational parameters such as, pump/pressure values and volume flow values, the selection of the distribution chains **111A, 111B** and filtering are implemented in accordance with the determinations provided by the control module **110B** in order to conduct the depurating process while maintaining the data processing assemblies **120A-120M** operational.

Returning back to FIG. 1, as shown, the depurating apparatus **110** further includes a fluid coupling section **110D** that is fluidly connected to the control structure **110C.** As best seen in FIG. 2B, which illustrates a high-level functional block diagram of the fluid coupling section **110D** in accordance with the implementations of the present technology, the coupling section **110D** comprises a front-end valve **114A** for allowing/preventing ingress of the filtered treated liquid supplied by the fluid control structure **110C,** a pressure control valve PCV, an air vent isolation valve AAV **114C,** and a back-end valve **114B** for allowing/preventing the supply of the treated liquid into the server rack liquid cooling loop **123.**

In particular, the fluid coupling section **110D** receives the treated liquid from the fluid control structure **110C** and incorporates a front-end valve **114A** for allowing/preventing ingress of the treated liquid. Upon ingress of the treated liquid, the automatic air vent valve AAV **114C** operates to bleed any air *(i.e.,* air bubbles/pockets) out of the treated liquid within the closed loop system and ensure that the treated liquid is substantially free of air pockets.

The treated liquid is then directed to a pressure control valve (PCV) **114D** configured to enable the injection of the treated liquid into the server rack liquid cooling loop **123** while maintaining the internal pressure and volume levels of the existing liquid within the server rack liquid cooling loop **123** and liquid cooling blocks at constant adequate levels. After the PCV **114D,** the treated liquid is forwarded to a back-end valve **114B** for allowing/preventing the treated liquid to be injected into the fluidly-coupled server rack liquid cooling loop **123** for circulation therethrough and purging of the existing liquid. In so doing, the depurating operation cycle is executed while maintaining the data processing assemblies **120A-120M** operational throughout the process.

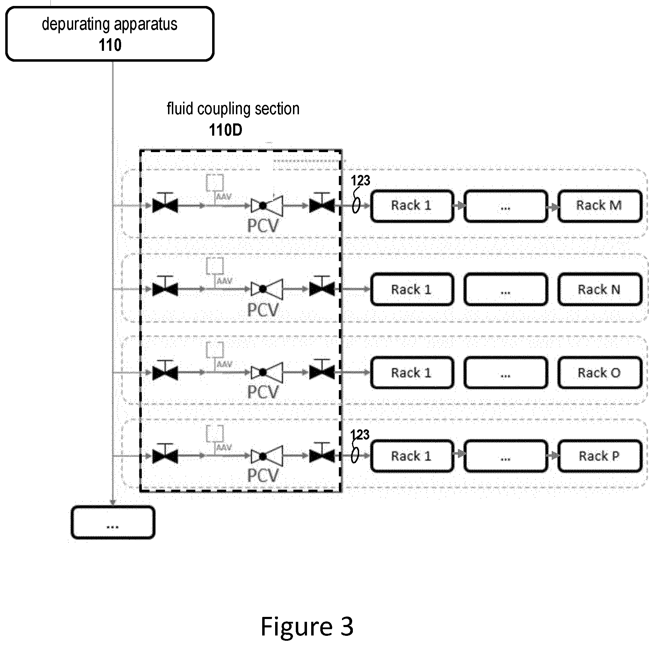

With this said, FIG. 3 illustrates a high-level schematic of the fluid coupling section **110D** connected to the datacenter server rack units **120,** in accordance with the nonlimiting implementations of the present technology. As shown, the fluid coupling **110D** of the depurating apparatus **110** is configured to fluidly connect to a plurality of racks for supplying the treated liquid for circulation via the server rack units liquid cooling loop **123** and purging the existing "dirty" liquid away, while maintaining the processing assemblies of the server rack units **120** in operation with no downtime.

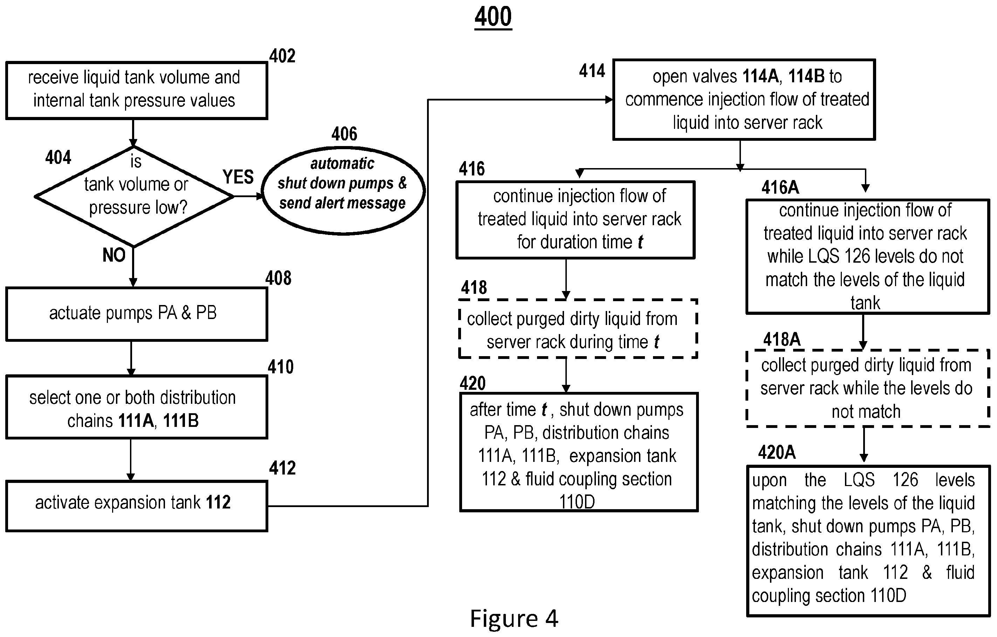

FIG. 4 illustrates a high-level flow diagram for the depurating process **400,** in accordance with the nonlimiting implementations of the present technology. As noted above, depurating process **400** is configured to be executed while maintaining the data processing assemblies **120A-120M** operational throughout the process.

In the disclosed implementation, depurating process **400** or portions thereof are referenced as being executed by control module **110B** for tractability purposes. However, the exact entity or entities executing depurating process **400** or portions thereof should not be interpreted as being limiting with regard to the concepts provided by the instant disclosure.

With this said, process **400** commences at task block **402** where the volume and internal pressure of the treated liquid tank is received based on the measured values by pressure sensor *pᵢₙ.* In certain implementations, the measured pressure value should register approx. between 0.05-0.2bar for proper operations. At decision block **404,** process **400** determines whether the volume and/or internal pressure of the treated liquid tank is below the threshold values for proper operations. If so, at task block **406,** process **400** automatically shuts down pumps PA, PB and transmits an alert message to operators. If the volume and/or internal pressure of the treated liquid tank are not below the threshold values for proper operations, process **400** moves to task block **408** in which pumps PA, PB corresponding the distribution chains **111A, 111B** are actuated for operation.

At task block **410,** process **400** selects one or both distribution chains **111A, 111B** of the fluid control structure **110C** to supply the treated liquid to be injected into the server rack(s). The selection of the distribution chains **111A, 111B** may be based on the estimated cooling liquid demands of particular server rack(s) and/or the pressure/volume levels required for proper operations.

At task block **412,** the expansion tank **112** of the fluid control structure **110C** is activated to ensure the constant proper pressure and volume flow of the treated liquid to be supplied to the server rack(s). Then, at task block **414,** valves **114A, 114B** of the fluid coupling section **110D** are opened to commence the flow of the treated liquid to be injected into the server rack(s). As noted above, the AAV **114C** operates to bleed out any air pockets or bubbles from the treated liquid and the PCV **114D** operates to maintain the internal pressure and volume levels of the existing liquid within the server rack liquid cooling loop **123** and liquid cooling blocks at constant adequate levels (e.g., approx. between 0.2 to 0.9bar).

After the injection flow of the treated liquid has commenced, the present technology embodies two implementations for the duration of the injection procedure. Therefore, in a first implementation of the present technology, at task block **416,** the injection flow of the treated liquid into the server rack(s) continues for a predetermined duration time ***t*.** The duration time ***t*** may be based on, for example, historical practices and experience. Then, at task block **418,** the "dirty" liquid purged from the rack(s) may be collected for recleaning/refiltering/recirculation purposes.

Finally, after duration time ***t*** has lapsed, process **400** shuts down pumps PA, PB, distribution chains **111A, 111B,** expansion tank **112,** and fluid coupling section **110D.**

Alternatively, in another implementation of the present technology, at task block **416A,** the injection flow of the treated liquid into the server rack(s) continues while the quality levels measured by the LQS **126** of the purged dirty liquid do not match the registered quality levels of the treated liquid in the liquid tank **110A.**

At task block **418A,** the dirty liquid purged from the server rack(s) may be collected for recleaning/re-filtering/recirculation purposes. Then, upon the LQS **126** quality levels matching the quality levels of the treated liquid in the liquid tank **110A,** at task block **420A,** process **400** shuts down pumps PA, PB, distribution chains **111A, 111B,** expansion tank **112,** and fluid coupling section **110D.**

In this manner, the depurating system **100** and corresponding process **400** effectively eliminate the buildup of undesirable contaminants throughout liquid cooling configurations of rack-mounted data processing assemblies as well as reduce reoccurrences of the same by furnishing treated cooling liquids. Moreover, the depurating system **100** and corresponding process **400** are capable of performing depurating cycle while the data processing assemblies are still in operation with no processing downtime.

While the above-described implementations have been described and shown with reference to particular steps performed in a particular order, it will be understood that these steps may be combined, sub-divided, or re-ordered without departing from the teachings of the present technology. At least some of the steps may be executed in parallel or in series. Accordingly, the order and grouping of the steps is not a limitation of the present technology.

It will be appreciated that at least some of the operations of the method 1300 may also be performed by computer programs, which may exist in a variety of forms, both active and inactive. Such as, the computer programs may exist as software program(s) comprised of program instructions in source code, object code, executable code or other formats. Any of the above may be embodied on a computer readable medium, which includes storage devices and signals, in compressed or uncompressed form. Representative computer readable storage devices include conventional computer system RAM (random access memory), ROM (read only memory), EPROM (erasable, programmable ROM), EEPROM (electrically erasable, programmable ROM), and magnetic or optical disks or tapes. Representative computer readable signals, whether modulated using a carrier or not, are signals that a computer system hosting or running the computer program may be configured to access, including signals downloaded through the Internet or other networks. Concrete examples of the foregoing include distribution of the programs on a CD ROM or via Internet download. In a sense, the Internet itself, as an abstract entity, is a computer readable medium. The same is true of computer networks in general.

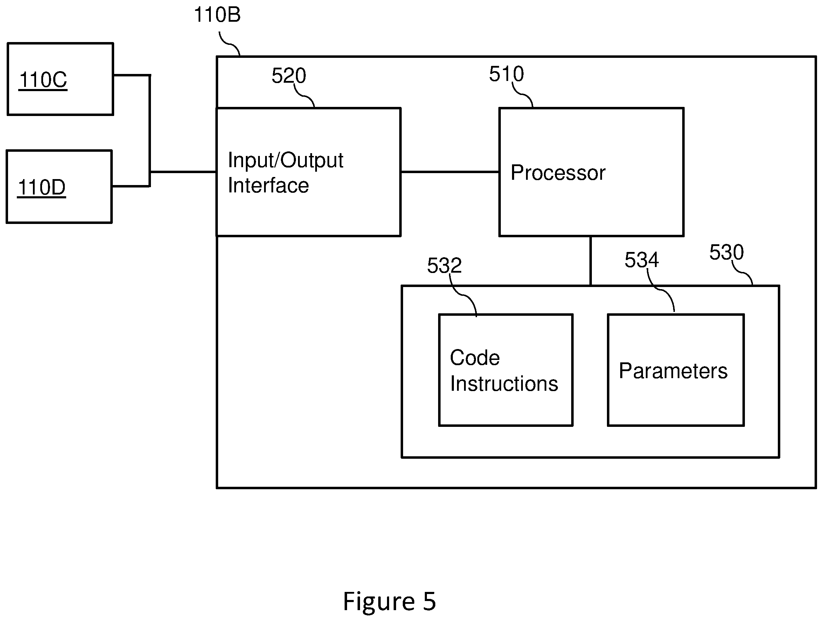

As an example, FIG. 5 is a schematic block diagram of the control module **110B** of the depurating system **100** according to some implementations of the present technology. The control module **110B** comprises a processor or a plurality of cooperating processors (represented as a processor **510** for simplicity), a memory device or a plurality of memory devices (represented as a memory device **530** for simplicity), and an input/output interface **520** allowing the control module **110B** to communicate with other components of the depurating system **100** and/or other components in remote communication with the depurating system **100.** The processor **510** is operatively connected to the memory device **530** and to the input/output interface **520.** The memory device **530** includes a storage for storing parameters **534.** The memory device **530** may comprise a non-transitory computer-readable medium for storing code instructions **532** that are executable by the processor **510** to allow the control module **110B** to perform the various tasks allocated to the control module **110B** in the process **400.**

The control module **110B** is operatively connected, via the input/output interface **520,** to the fluid control structure **110C.** In some implementations, the control module **110B** is also operatively connected to the fluid coupling section **110D.** The control module **110B** executes the code instructions **532** stored in the memory device **530** to implement the various above-described functions that may be present in a particular implementation. FIG. 5 as illustrated represents a non-limiting implementation in which the control module **110B** orchestrates operations of the process **400.** This particular implementation is not meant to limit the present disclosure and is provided for illustration purposes.

It will be understood that the features and examples above are not meant to limit the scope of the present disclosure to a single implementation, as other implementations are possible by way of interchange of some or all of the described or illustrated elements, as long as such implementations fall under the scope of the present invention, which is defined in the appended claims. Moreover, where certain elements of the present disclosure can be partially or fully implemented using known components, only those portions of such known components that are necessary for an understanding of the present disclosure are described, and detailed descriptions of other portions of such known components are omitted so as not to obscure the disclosure. In the present specification, an implementation showing a singular component should not necessarily be limited to other implementations including a plurality of the same component, and vice-versa, unless explicitly stated otherwise herein. Moreover, applicants do not intend for any term in the specification or claims to be ascribed to an uncommon or special meaning unless explicitly set forth as such. Further, the present disclosure encompasses present and future known equivalents to the known components referred to herein by way of illustration.

The present description of the specific implementations so fully reveals the general nature of the disclosure that others can, by applying knowledge within the skill of the relevant art(s) readily modify and/or adapt for various applications such specific implementations, without undue experimentation and without departing from the general concept of the present invention, which is defined in the appeded claims. Such adaptations and modifications are therefore intended to be within the meaning and range of equivalents of the disclosed implementations, based on the teaching and guidance presented herein. It is to be understood that the phraseology or terminology herein is for the purpose of description and not of limitation, such that the terminology or phraseology of the present specification is to be interpreted by the skilled artisan in light of the teachings and guidance presented herein, in combination with the knowledge of one skilled in the relevant art(s).

The foregoing description is intended to be exemplary rather than limiting. The scope of the present technology is therefore intended to be limited solely by the scope of the appended claims.

## Claims

1. A depurating system (100) for a server rack (120) housing rack-mounted processing assemblies (120A-120M) that are cooled by respective liquid cooling blocks channeling a cooling liquid via a liquid cooling loop (123), comprising:
a depurating apparatus (110) comprising:
a tank (110A) containing a volume of liquid treated with cleansing additives,
a control module (110B) configured to monitor, determine, and control at least one operational parameter regarding the treated liquid,
a fluid control structure (110C) operably-coupled to the control module (110B) and configured to adjust the at least one operational parameter of the treated liquid based on determinations provided by the control module (110B), and
a fluid coupling section (110D) fluidly-coupled to the fluid control structure (110C) and configured to supply the treated liquid to the server rack (120), the fluid coupling section comprising a pressure control valve (PCV) (114D) and a back-end valve (114B);
a server rack fluid inlet (122) fluidly-connected to the fluid coupling section (110D) for receiving the supplied treated liquid and fluidly-coupled to an input side of the liquid cooling loop (123) for injecting the treated liquid for distribution throughout the processing assemblies (120A-120M) of the server rack (120); and
a server rack fluid outlet (124) fluidly-coupled to an output side of the liquid cooling loop (123) for receiving the existing cooling liquid displaced by the injected treated liquid;
wherein the PCV (114D) is configured to provide the injection of the treated liquid functions into the liquid cooling loop (123) to purge the existing cooling liquid away from the rack-mounted processing assemblies (120A-120M) of the server rack (120) and replace the purged existing cooling liquid with the treated liquid while maintaining continued operations of the rack-mounted processing assemblies (120A-120M) and
wherein the back-end valve (114B) is configured to control the supply of the treated liquid into the server rack liquid cooling loop (123).

2. The depurating system (100) of claim 1, further comprising:
a purging pipe (125) fluidly-coupled to the server rack unit fluid outlet (124) and configured to receive the purged existing cooling liquid; and
a liquid quality sensor (LQS) (126) fluidly-coupled to the purging pipe (125) for measuring quality levels of the purged existing liquid.

3. The depurating system (100) of claims 1 or 2, wherein the treated liquid comprises reversed osmosed water containing at least one corrosion inhibiting agent.

4. The depurating system (100) of anyone of claims 1 to 3, wherein the treated liquid further comprises quality levels having a pH balance of approximately between 8 and 10, an electrical conductivity of approximately less than 170 (µS/cm), an aluminum, copper, and zinc content of approximately less than 0.6 ppm and an aerobic microorganism content of approximately less than 1000 cfu/ml.

5. The depurating system (100) of anyone of claims 1 to 4, wherein the fluid control structure (110C) comprises at least one pump (PA, PB), at least one pressure sensor (pᵢₙ, pₐ, p_{b}), at least one filter (F), an expansion tank (112), and at least one check control valve (CVᵢₙ, CVA, CVB).

6. The depurating system (100) of anyone of claims 1 to 5, wherein the fluid coupling section (110D) further comprises at least one air vent isolation valve (114C), and at least one shutoff flow valve (114A, 114B).

7. The depurating system (100) of anyone of claims 1 to 6, wherein the at least one operational parameter includes one of a tank (110A) internal volume level, a tank (110A) internal pressure level, and/or a pump (PA, PB) pressure level.

8. The depurating system (100) of anyone of claims 1 to 7, wherein the injection of the treated liquid is performed until a predetermined duration time t has lapsed.

9. The depurating system (100) of anyone of claims 2 to 7, wherein the injection of the treated liquid is performed until quality levels of the purged existing cooling liquid, as measured by the LQS (126), matches the treated liquid quality levels.

10. A depurating process (400) for a server rack (120) housing rack-mounted processing assemblies (120A-120M) that are cooled by respective liquid cooling blocks channeling a cooling liquid via a liquid cooling loop (123), comprising:
providing a depurating system according to claim 1,
detecting an internal volume and pressure of a liquid tank (110A) containing a treated depurating liquid, the treated depurating liquid comprising reversed osmosed water containing at least one corrosion inhibiting agent;
determining whether the internal volume and/or pressure of the treated liquid tank is below an acceptable threshold value;
upon determining that the internal volume and/or pressure of the treated liquid tank is below the acceptable threshold value, shut down the process and send an alert message;
upon determining that the internal volume and/or pressure of the treated liquid tank meets the acceptable threshold value, execute the process by:
actuating pumps (PA, PB) corresponding to liquid distribution chains (111A, 111B) of the treated liquid;
selecting at least one of the liquid distribution chains (111A, 111B) for distributing the treated liquid to the rack-mounted processing assembly (120A-120M);
activate an expansion tank to ensure constant pressure and volume of the treated liquid to be distributed to the rack-mounted processing assembly (120A-120M); and
commence injection flow of the treated liquid into the liquid cooling loop (123) of the server rack unit (120);
wherein the injection flow of the treated liquid functions to purge existing cooling liquid from the rack-mounted processing assemblies (120A-120M) of the server rack (120) and replace the purged existing cooling liquid with the treated liquid while maintaining continued operations of the rack-mounted processing assemblies (120A-120M).

11. The depurating process (400) of claim 10, wherein the treated liquid further comprises quality levels having a pH balance of approximately between 8 and 10, an electrical conductivity of approximately less than 170 (µS/cm), an aluminum, copper, and zinc content of approximately less than 0.6 ppm and an aerobic microorganism content of approximately less than 1000 cfu/ml.

12. The depurating process (400) of claims 10 or 11, wherein the injection of the treated liquid and the purging of existing liquid is performed until a predetermined duration time t has lapsed.

13. The depurating process (400) of claim 11, wherein the injection of the treated liquid and the purging of existing liquid is performed until quality levels of the purged existing cooling liquid match the treated liquid quality levels.

14. The depurating process (400) of claim 12, wherein after the lapse of during time ***t*,** the pumps PA, PB, distribution chains (111A, 111B), expansion tank (112) and fluid coupling section (110D) are shut down.

15. The depurating process (400) of claim 13, wherein upon the quality levels of the purged existing cooling liquid matching the treated liquid quality levels, pumps PA, PB, distribution chains (111A, 111B), expansion tank (112) and fluid coupling section (110D) are shut down.

## Patentansprüche

1. Reinigungssystem (100) für ein Servergestell (120), das gestellmontierte Verarbeitungsbaugruppen (120A-120M) aufnimmt, die durch jeweilige Flüssigkeitskühlblöcke gekühlt werden, die eine Kühlflüssigkeit über einen Flüssigkeitskühlkreislauf (123) leiten, umfassend:
eine Reinigungseinrichtung (110), umfassend:
einen Tank (110A), der ein Volumen an Flüssigkeit enthält, die mit Reinigungszusätzen behandelt ist,
ein Steuermodul (110B), das dazu ausgebildet ist, mindestens einen Betriebsparameter bezüglich der behandelten Flüssigkeit zu überwachen, zu bestimmen und zu steuern,
eine Fluidsteuerstruktur (110C), die mit dem Steuermodul (110B) wirkgekoppelt und dazu ausgebildet ist, den mindestens einen Betriebsparameter der behandelten Flüssigkeit auf Grundlage von durch das Steuermodul (110B) bereitgestellten Bestimmungen anzupassen, und
einen Fluidkopplungsabschnitt (110D), der mit der Fluidsteuerstruktur (110C) fluidisch gekoppelt und dazu ausgebildet ist, die behandelte Flüssigkeit dem Servergestell (120) zuzuführen, wobei der Fluidkopplungsabschnitt ein Druckregelventil (PCV) (114D) und ein Back-End-Ventil (114B) umfasst;
einen Servergestell-Fluideinlass (122), der mit dem Fluidkopplungsabschnitt (110D) fluidisch verbunden ist, um die zugeführte behandelte Flüssigkeit aufzunehmen, und mit einer Eingangsseite des Flüssigkeitskühlkreislaufs (123) fluidisch gekoppelt ist, um die behandelte Flüssigkeit zur Verteilung über die Verarbeitungsbaugruppen (120A-120M) des Servergestells (120) einzuspritzen; und
einen Servergestell-Fluidauslass (124), der mit einer Ausgangsseite des Flüssigkeitskühlkreislaufs (123) fluidisch gekoppelt ist, um die vorhandene Kühlflüssigkeit aufzunehmen, die durch die eingespritzte behandelte Flüssigkeit verdrängt wird;
wobei das PCV (114D) dazu ausgebildet ist, die Einspritzung der behandelten Flüssigkeit Funktionen in den Flüssigkeitskühlkreislauf (123) bereitzustellen, um die vorhandene Kühlflüssigkeit aus den gestellmontierten Verarbeitungsbaugruppen (120A-120M) des Servergestells (120) auszuspülen und die ausgespülte vorhandene Kühlflüssigkeit durch die behandelte Flüssigkeit zu ersetzen, während der fortgesetzte Betrieb der gestellmontierten Verarbeitungsbaugruppen (120A-120M) aufrechterhalten wird, und
wobei das Back-End-Ventil (114B) dazu ausgebildet ist, die Zufuhr der behandelten Flüssigkeit in den Servergestell-Flüssigkeitskühlkreislauf (123) zu steuern.

2. Reinigungssystem (100) nach Anspruch 1, ferner umfassend:
ein Spülrohr (125), das mit dem Servergestelleinheit-Fluidauslass (124) fluidisch gekoppelt und dazu ausgebildet ist, die ausgespülte vorhandene Kühlflüssigkeit aufzunehmen; und
einen Flüssigkeitsqualitätssensor (LQS) (126), der mit dem Spülrohr (125) fluidisch gekoppelt ist, um Qualitätswerte der ausgespülten vorhandenen Flüssigkeit zu messen.

3. Reinigungssystem (100) nach Anspruch 1 oder 2, wobei die behandelte Flüssigkeit Umkehrosmosewasser umfasst, das mindestens ein korrosionshemmendes Mittel enthält.

4. Reinigungssystem (100) nach einem der Ansprüche 1-3, wobei die behandelte Flüssigkeit ferner Qualitätswerte umfasst, die einen pH-Wert von etwa zwischen 8 und 10, eine elektrische Leitfähigkeit von etwa weniger als 170 (µS/cm), einen Aluminium-, Kupfer- und Zinkgehalt von etwa weniger als 0,6 ppm und einen Gehalt an aeroben Mikroorganismen von etwa weniger als 1000 KBE/ml aufweisen.

5. Reinigungssystem (100) nach einem der Ansprüche 1-4, wobei die Fluidsteuerstruktur (110C) mindestens eine Pumpe (PA, PB), mindestens einen Drucksensor (pᵢₙ, pₐ, p_{b}), mindestens einen Filter (F), einen Ausdehnungsbehälter (112) und mindestens ein Rückschlagsteuerventil (CVᵢₙ, CVA, CVB) umfasst.

6. Reinigungssystem (100) nach einem der Ansprüche 1-5, wobei der Fluidkopplungsabschnitt (110D) ferner mindestens ein Entlüftungsabsperrventil (114C) und mindestens ein Durchflussabsperrventil (114A, 114B) umfasst.

7. Reinigungssystem (100) nach einem der Ansprüche 1-6, wobei der mindestens eine Betriebsparameter eines von einem Innenvolumenniveau eines Tanks (110A), einem Innendruckniveau eines Tanks (110A) und/oder einem Druckniveau einer Pumpe (PA, PB) umfasst.

8. Reinigungssystem (100) nach einem der Ansprüche 1-7, wobei die Einspritzung der behandelten Flüssigkeit durchgeführt wird, bis eine vorbestimmte Zeitdauer ***t*** abgelaufen ist.

9. Reinigungssystem (100) nach einem der Ansprüche 2-7, wobei die Einspritzung der behandelten Flüssigkeit durchgeführt wird, bis Qualitätswerte der ausgespülten vorhandenen Kühlflüssigkeit, wie durch den LQS (126) gemessen, den Qualitätswerten der behandelten Flüssigkeit entsprechen.

10. Reinigungsverfahren (400) für ein Servergestell (120), das gestellmontierte Verarbeitungsbaugruppen (120A-120M) aufnimmt, die durch jeweilige Flüssigkeitskühlblöcke gekühlt werden, die eine Kühlflüssigkeit über einen Flüssigkeitskühlkreislauf (123) leiten, umfassend:
Bereitstellen eines Reinigungssystems nach Anspruch 1,
Erfassen eines Innenvolumens und eines Drucks eines Flüssigkeitstanks (110A), der eine behandelte Reinigungsflüssigkeit enthält, wobei die behandelte Reinigungsflüssigkeit Umkehrosmosewasser umfasst, das mindestens ein korrosionshemmendes Mittel enthält;
Bestimmen, ob das Innenvolumen und/oder der Druck des Tanks für behandelte Flüssigkeit unter einem zulässigen Schwellenwert liegt;
bei Bestimmen, dass das Innenvolumen und/oder der Druck des Tanks für behandelte Flüssigkeit unter dem zulässigen Schwellenwert liegt, das Verfahren abschalten und eine Warnmeldung senden;
bei Bestimmen, dass das Innenvolumen und/oder der Druck des Tanks für behandelte Flüssigkeit den zulässigen Schwellenwert erfüllt, das Verfahren ausführen durch:
Betätigen von Pumpen (PA, PB), die Flüssigkeitsverteilungsketten (111A, 111B) der behandelten Flüssigkeit entsprechen;
Auswählen mindestens einer der Flüssigkeitsverteilungsketten (111A, 111B) zum Verteilen der behandelten Flüssigkeit an die gestellmontierte Verarbeitungsbaugruppe (120A-120M);
einen Ausdehnungsbehälter aktivieren, um einen konstanten Druck und ein konstantes Volumen der an die gestellmontierte Verarbeitungsbaugruppe (120A-120M) zu verteilenden behandelten Flüssigkeit sicherzustellen; und
Einspritzströmung der behandelten Flüssigkeit in den Flüssigkeitskühlkreislauf (123) der Servergestelleinheit (120) einleiten;
wobei die Einspritzströmung der behandelten Flüssigkeit dazu dient, vorhandene Kühlflüssigkeit aus den gestellmontierten Verarbeitungsbaugruppen (120A-120M) des Servergestells (120) auszuspülen und die ausgespülte vorhandene Kühlflüssigkeit durch die behandelte Flüssigkeit zu ersetzen, während der fortgesetzte Betrieb der gestellmontierten Verarbeitungsbaugruppen (120A-120M) aufrechterhalten wird.

11. Reinigungsverfahren (400) nach Anspruch 10, wobei die behandelte Flüssigkeit ferner Qualitätswerte umfasst, die einen pH-Wert von etwa zwischen 8 und 10, eine elektrische Leitfähigkeit von etwa weniger als 170 (µS/cm), einen Aluminium-, Kupfer- und Zinkgehalt von etwa weniger als 0,6 ppm und einen Gehalt an aeroben Mikroorganismen von etwa weniger als 1000 KBE/ml aufweisen.

12. Reinigungsverfahren (400) nach Anspruch 10 oder 11, wobei die Einspritzung der behandelten Flüssigkeit und das Ausspülen vorhandener Flüssigkeit durchgeführt werden, bis eine vorbestimmte Zeitdauer ***t*** abgelaufen ist.

13. Reinigungsverfahren (400) nach Anspruch 11, wobei die Einspritzung der behandelten Flüssigkeit und das Ausspülen vorhandener Flüssigkeit durchgeführt werden, bis Qualitätswerte der ausgespülten vorhandenen Kühlflüssigkeit den Qualitätswerten der behandelten Flüssigkeit entsprechen.

14. Reinigungsverfahren (400) nach Anspruch 12, wobei nach Ablauf der Zeitdauer t die Pumpen PA, PB, Verteilungsketten (111A, 111B), Ausdehnungsbehälter (112) und Fluidkopplungsabschnitt (110D) abgeschaltet werden.

15. Reinigungsverfahren (400) nach Anspruch 13, wobei, sobald die Qualitätswerte der ausgespülten vorhandenen Kühlflüssigkeit den Qualitätswerten der behandelten Flüssigkeit entsprechen, Pumpen PA, PB, Verteilungsketten (111A, 111B), Ausdehnungsbehälter (112) und Fluidkopplungsabschnitt (110D) abgeschaltet werden.

## Revendications

1. Système de purification (100) pour une baie de serveurs (120) abritant des ensembles de traitement montés sur bâti (120A-120M) refroidis par des blocs de refroidissement liquide respectifs acheminant un liquide de refroidissement par une boucle de refroidissement liquide (123), comprenant :
un appareil de purification (110) comprenant :
un réservoir (110A) contenant un volume de liquide traité avec des additifs nettoyants,
un module de commande (110B) configuré pour surveiller, déterminer et contrôler au moins un paramètre opérationnel concernant le liquide traité,
une structure de contrôle des fluides (110C) couplée de manière fonctionnelle au module de commande (110B) et configurée pour ajuster le au moins un paramètre opérationnel du liquide traité sur la base des déterminations fournies par le module de commande (110B), et
une section de couplage des fluides (110D) couplée fluidiquement à la structure de contrôle des fluides (110C) et configurée pour fournir le liquide traité à la baie de serveurs (120), la section de couplage des fluides comprenant une vanne de régulation de pression (PCV) (114D) et une vanne arrière (114B) ;
une entrée de fluide de la baie de serveurs (122) reliée fluidiquement à la section de couplage des fluides (110D) pour recevoir le liquide traité fourni et couplée fluidiquement à un côté d'entrée de la boucle de refroidissement liquide (123) pour injecter le liquide traité en vue de sa distribution dans les ensembles de traitement (120A-120M) de la baie de serveurs (120) ; et
une sortie de fluide de la baie de serveurs (124) couplée fluidiquement à un côté de sortie de la boucle de refroidissement liquide (123) pour recevoir le liquide de refroidissement existant déplacé par le liquide traité injecté ;
dans lequel la PCV (114D) est configurée pour assurer l'injection du liquide traité dans la boucle de refroidissement liquide (123) afin de purger le liquide de refroidissement existant des ensembles de traitement montés sur bâti (120A-120M) de la baie de serveurs (120) et de remplacer le liquide de refroidissement existant purgé par le liquide traité tout en maintenant le fonctionnement continu des ensembles de traitement montés sur bâti (120A-120M) et
dans lequel la vanne arrière (114B) est configurée pour contrôler l'alimentation du liquide traité dans la boucle de refroidissement liquide de la baie de serveurs (123).

2. Système de purification (100) selon la revendication 1, comprenant en outre :
un tuyau de purge (125) raccordé fluidiquement à la sortie de fluide (124) de l'unité de baie de serveurs et configuré pour recevoir le liquide de refroidissement existant purgé ; et
un capteur de qualité de liquide (LQS) (126) couplé fluidiquement au tuyau de purge (125) pour mesurer les niveaux de qualité du liquide existant purgé.

3. Système de purification (100) selon la revendication 1 ou 2, dans lequel le liquide traité comprend de l'eau osmosée inverse contenant au moins un agent inhibiteur de corrosion.

4. Système de purification (100) selon l'une quelconque des revendications 1 à 3, dans lequel le liquide traité comprend en outre des niveaux de qualité ayant un équilibre de pH d'environ entre 8 et 10, une conductivité électrique d'environ moins de 170 (µS/cm), une teneur en aluminium, en cuivre et en zinc d'environ moins de 0,6 ppm, et une teneur en micro-organismes aérobies d'environ moins de 1 000 cfu/ml.

5. Système de purification (100) selon l'une quelconque des revendications 1 à 4, dans lequel la structure de contrôle des fluides (110C) comprend au moins une pompe (PA, PB), au moins un capteur de pression (pᵢₙ, pₐ, p_{b}), au moins un filtre (F), un réservoir d'expansion (112) et au moins un clapet anti-retour (CVᵢₙ, CVA, CVB).

6. Système de purification (100) selon l'une quelconque des revendications 1 à 5, dans lequel la section de couplage des fluides (110D) comprend en outre au moins une vanne d'isolement de purge d'air (114C) et au moins une vanne d'arrêt de débit (114A, 114B).

7. Système de purification (100) selon l'une quelconque des revendications 1 à 6, dans lequel le au moins un paramètre opérationnel comporte un d'un niveau de volume interne d'un réservoir (110A), d'un niveau de pression interne d'un réservoir (110A) et/ou d'un niveau de pression d'une pompe (PA, PB).

8. Système de purification (100) selon l'une quelconque des revendications 1 à 7, dans lequel l'injection du liquide traité est effectuée jusqu'à ce qu'une durée prédéterminée ***t*** se soit écoulée.

9. Système de purification (100) selon l'une quelconque des revendications 2 à 7, dans lequel l'injection du liquide traité est effectuée jusqu'à ce que des niveaux de qualité du liquide de refroidissement existant purgé, tels que mesurés par le LQS (126), correspondent aux niveaux de qualité du liquide traité.

10. Procédé de purification (400) pour une baie de serveurs (120) abritant des ensembles de traitement montés sur bâti (120A-120M) refroidis par des blocs de refroidissement liquide respectifs acheminant un liquide de refroidissement par une boucle de refroidissement liquide (123), comprenant les étapes suivantes :
fournir un système de purification selon la revendication 1, détectant un volume interne et une pression d'un réservoir de liquide (110A) contenant un liquide de purification traité, le liquide de purification traité comprenant de l'eau osmosée inverse contenant au moins un agent inhibiteur de corrosion ;
déterminer si le volume interne et/ou la pression du réservoir de liquide traité sont inférieurs à une valeur seuil acceptable ;
après avoir déterminé que le volume interne et/ou la pression du réservoir de liquide traité sont inférieurs à la valeur seuil acceptable, arrêter le procédé et envoyer un message d'alerte ;
après avoir déterminé que le volume interne et/ou la pression du réservoir de liquide traité atteignent la valeur seuil acceptable, exécuter le procédé en :
activant les pompes (PA, PB) correspondant aux chaînes de distribution de liquide (111A, 111B) du liquide traité ;
sélectionnant au moins une des chaînes de distribution de liquide (111A, 111B) pour distribuer le liquide traité à l'ensemble de traitement monté sur bâti (120A-120M) ;
activant un réservoir d'expansion pour assurer une pression et un volume constants du liquide traité à distribuer à l'ensemble de traitement monté sur bâti (120A-120M) ; et
commençant le flux d'injection du liquide traité dans la boucle de refroidissement liquide (123) de l'unité de la baie de serveur (120) ;
dans lequel le flux d'injection du liquide traité purge le liquide de refroidissement existant des ensembles de traitement montés sur bâti (120A-120M) de la baie de serveurs (120) et remplace le liquide de refroidissement existant purgé par le liquide traité, tout en maintenant des opérations continues des ensembles de traitement montés sur bâti (120A-120M).

11. Procédé de purification (400) selon la revendication 10, dans lequel le liquide traité comprend en outre des niveaux de qualité ayant un équilibre de pH d'environ entre 8 et 10, une conductivité électrique d'environ moins de 170 (µS/cm), une teneur en aluminium, en cuivre et en zinc d'environ moins de 0,6 ppm, et une teneur en micro-organismes aérobies d'environ moins de 1 000 cfu/ml.

12. Procédé de purification (400) selon la revendication 10 ou 11, dans lequel l'injection du liquide traité et la purge du liquide existant sont effectuées jusqu'à ce qu'une durée prédéterminée ***t*** se soit écoulée.

13. Procédé de purification (400) selon la revendication 11, dans lequel l'injection du liquide traité et la purge du liquide existant sont effectuées jusqu'à ce que les niveaux de qualité du liquide de refroidissement existant purgé correspondent aux niveaux de qualité du liquide traité.

14. Procédé de purification (400) selon la revendication 12, dans lequel, après l'écoulement du temps t, les pompes PA, PB, les chaînes de distribution (111A, 111B), le réservoir d'expansion (112) et la section de couplage des fluides (110D) sont arrêtés.

15. Procédé de purification (400) selon la revendication 13, dans lequel, lorsque les niveaux de qualité du liquide de refroidissement existant purgé correspondent aux niveaux de qualité du liquide traité, les pompes PA, PB, les chaînes de distribution (111A, 111B), le réservoir d'expansion (112) et la section de couplage des fluides (110D) sont arrêtés.
